(19) Europäisches Patentamt

European Patent Office

Office européen des brevets

(11) EP 1 672 372 A1

(12) EUROPEAN PATENT APPLICATION
published in accordance with Art. 158(3) EPC

(43) Date of publication:
21.06.2006 Bulletin 2006/25

(51) Int Cl.:
*G01P 3/481* (1980.01)    *G01D 5/245* (1968.09)

(21) Application number: 04772656.7

(22) Date of filing: 26.08.2004

(86) International application number:
PCT/JP2004/012700

(87) International publication number:
WO 2005/026744 (24.03.2005 Gazette 2005/12)

(84) Designated Contracting States:
DE FR GB

(30) Priority: 11.09.2003  JP 2003320058
10.11.2003  JP 2003379536
22.04.2004  JP 2004126311

(71) Applicant: NSK Ltd.
Shinagawa-ku,
Tokyo 141-8560 (JP)

(72) Inventor: ONO, Koichiro
c/o NSK Ltd.
Fujisawa-shi, Kanagawa 251-8501 (JP)

(74) Representative: Grünecker, Kinkeldey,
Stockmair & Schwanhäusser
Anwaltssozietät
Maximilianstrasse 58
80538 München (DE)

(54) **ROTATION SPEED DETECTION DEVICE AND ROLLING BEARING UNIT LOAD MEASUREMENT DEVICE**

(57)    A sensor for detecting a rotation speed outputs a detecting signal d expressing a speed superposed with an actual rotation speed $d_d$ and a variation amount $d_n$ based on whirling. By an adaptive filter 28 constituting a reference signal x by a signal generated by itself from a signal of the sensor, a cancel signal y for canceling the variation amount $d_n$ is calculated and the cancel signal is subtracted from the detecting signal d. As a result, a signal e expressing substantially the rotation speed $d_d$ is provided and therefore, based on the signal e, the rotation speed of the rotating member is calculated.

*FIG. 5*

**Description**

<Technical Field>

The present invention relates to a rotation speed detecting apparatus and a load measuring apparatus of a rolling bearing unit. For example, the invention relates to an improvement in a rolling bearing unit for supporting a wheel of a moving member of an automobile, a railroad vehicle, various carrying vehicles or the like utilized for ensuring stability in moving the moving member by measuring a rotation speed of a rotating member constituting the moving bearing unit and measuring a load (one or both of radial load and axial load) loaded on the rolling bearing unit.

<Background Art>

For example, a wheel of an automobile is rotatably supported by a suspension by a rolling bearing unit of a double row angular type. Further, in order to ensure a running stability of an automobile, there is used a vehicular running stabilizing apparatus of an antilock braking system (ABS), a traction control system (TCS), a vehicle stability control system (VSC) or the like. In order to control the various vehicular running stabilizing apparatus, a signal indicating a rotation speed of a vehicle, accelerations in respective directions applied on a vehicle body or the like becomes necessary. Further, in order to carry out a higher control, there is a case in which it is preferable to know a magnitude of a load (one or both of radial load and axial load) applied on the rolling bearing unit by way of the wheel.

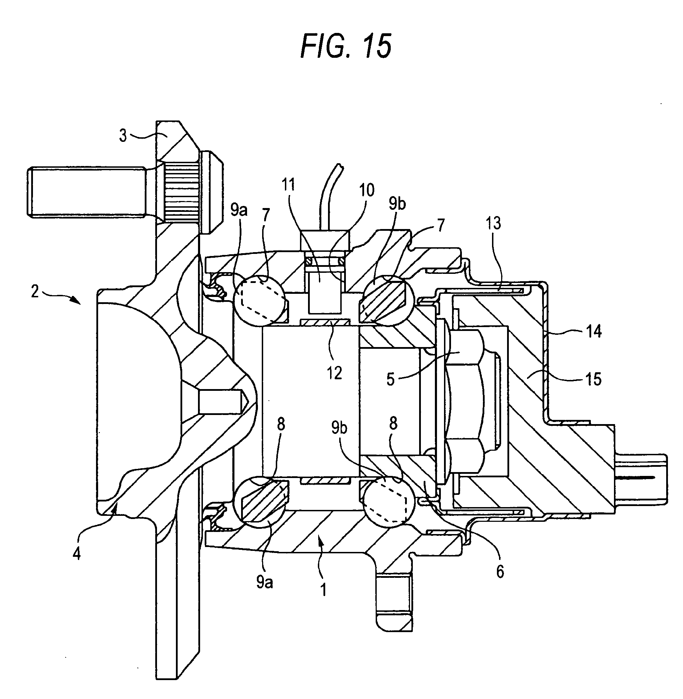

In view of such a situation, JP-A-2001-21577 (hereinafter, described as "Patent Reference 1") describes a rolling bearing unit having a load measuring apparatus capable of measuring a radial load. The rolling bearing unit having the load measuring apparatus according to a first example of the background art is for measuring the radial load and is constituted as shown by Fig. 15. A hub 2 constituting a rotating ring supported by a suspension for coupling to fix a wheel on an inner diameter side of an outer ring 1 constituting a stationary ring. The hub 2 is provided with a hub main body 4 having a rotating side flange 3 for fixing the wheel at an outer end portion thereof (an end portion constituting an outer side in a width direction in a state of being integrated to a vehicle), and an inner ring 6. The inner ring 6 is outwardly fitted to an inner end portion (an end portion constituting a center side in the width direction in the state of being integrated to the vehicle) of the hub main body 4 and pressed by a nut 5. An inner peripheral face of the outer ring 1 is formed with double rows of outer ring tracks 7, 7 respectively constituting stationary side tracks. An outer peripheral face of the hub 2 is formed with double rows of inner ring tracks 8, 8 respectively constituting rotating side tracks. Further, respective pluralities of pieces of rolling members 9a, 9b are arranged between double rows of the outer ring tracks 7, 7 of the outer ring 1 and double rows of inner ring tracks 8, 8 of the hub 2 to be able to rotate the hub 2 on the inner diameter side of the outer ring 1.

An attaching hole 10 penetrating the outer ring 1 in a diameter direction is formed at a middle portion in an axial direction of the outer ring 1 and a portion thereof between double rows of the outer ring tracks 7, 7 at an upper end portion of the outer ring 1 substantially in a vertical direction. Further, inside of the attaching hole 10 is mounted with a displacement sensor 11 in a shape of a circular rod (rod-like shape) constituting a sensor for measuring a load. The displacement sensor 11 is of a noncontact type and a detecting face provided at a front end face (lower end face) thereof is made to be opposed proximately to an outer peripheral face of a sensor ring 12 outwardly fitted to be fixed by a middle portion in an axial direction of the hub 2. The displacement sensor 11 outputs a signal when a distance between the detecting face and the outer peripheral face of the sensor ring 12 is changed in correspondence with an amount of the change.

In the case of the rolling bearing unit having the load measuring apparatus of the background art constituted as described above, based on the detecting signal of the displacement sensor 11, the load applied to the rolling bearing unit can be calculated. That is, whereas the outer ring 1 supported by the suspension of the vehicle is pressed to a lower side by a weight of the vehicle, the hub 2 fixedly supporting the wheel is going to stay at a position as it is. Therefore, the more the weight is increased, the more the deviation between the center of the outer ring 1 and the center of the hub 2 is increased based on elastic deformations of the outer ring 1 and the hub 2 as well as the rolling members 9a, 9b. Further, the more the weight is increased the shorter the distance between the detecting face of the displacement sensor 11 and the outer peripheral face of the sensor ring 12 provided at the upper end portion of the outer ring 1. Hence, when the detecting signal of the displacement sensor 11 is transmitted to a controller, the radial load applied to the rolling bearing unit integrated with the displacement sensor 11 can be calculated from a relationship or a map previously calculated by an experiment or the like. Based on the load applied on the respective rolling bearing units calculated in this way, ABS is properly controller, further, a failure in a loading state is informed to a driver.

Further, according to the background art structure shown in Fig. 15, in addition to the load applied to the rolling bearing unit, also a rotation speed of the hub 2 is made to be able to be detected. Therefore, a sensor rotor 13 is outwardly fitted to be fixed by an inner end portion of the inner ring 6 and a sensor 15 for detecting the rotation speed is supported by a cover 14 attached to an inner end opening portion of the outer ring 1. Further, a detecting portion of the rotation speed of the detecting sensor 15 is made to be opposed to a detected portion of the sensor rotor 13 by way of a detection clearance.

In using the rolling bearing unit integrated with the above-described rotation speed detecting apparatus, when the sensor rotor 13 is rotated along with the hub 2 fixed with the wheel and the detected portion of the sensor rotor 13 is made to run at a vicinity of the detecting portion of the rotation speed detecting sensor 15, an output of the rotation speed detecting sensor 15 is changed. A frequency of changing the output of the rotation speed detecting sensor 15 in this way is proportional to a rotational number of the wheel. Therefore, when an output signal of the rotation speed detecting sensor 15 is transmitted to a controller, not illustrated, ABS and TCS can pertinently be controlled.

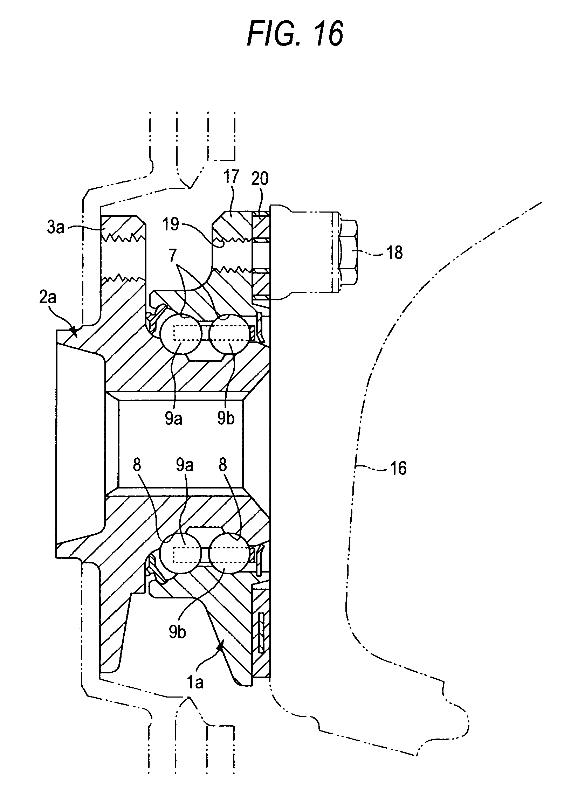

Although the rolling bearing unit having the load measuring apparatus of the first example of the above-described background art structure is for measuring the radial load applied to the rolling bearing unit, also a structure of measuring an axial load applied to the rolling bearing unit is described in JP-A-3-209016 (hereinafter, described as "Patent Reference 2") or the like and is known in the background art. Fig. 16 shows a rolling bearing unit having a load measuring apparatus described in Patent Reference 2 for measuring an axial load. In the case of a second example of the background art structure, a rotating side flange 3a for supporting a wheel is fixedly provided to an outer peripheral face of an outer end portion of a hub 2a constituting a rotating ring. Further, an outer peripheral face of an outer ring 1a constituting a stationary ring is fixedly provided with a fixed side flange 17 for fixedly supporting the outer ring 1a by a knuckle 16 constituting a suspension. Further, an inner peripheral face of the outer ring 1a is formed with double rows of the outer ring tracks 7, 7. An outer peripheral face of the hub 2a is formed with double rows of the inner ring tracks 8, 8. Further, by rollably providing respective pluralities of pieces of the rolling members 9a, 9b between double rows of the outer ring tracks 7, 7 of the outer ring 1a and double rows of the inner ring tracks 8, 8 of the hub 2a, the hub 2a is rotatably supported by an inner diameter side of the outer ring 1a.

Further, respective load sensors 20 are attached to a plurality of portions of an inner side face of the fixed side flange 17 and portions thereof surrounding screw holes 19 for screwing bolts 18 for coupling the fixed side flange 17 of the knuckle 16. In a state of fixedly supporting the outer ring 1a by the knuckle 16, the respective load sensors 20 are supported between an outer side of the knuckle 16 and an inner side face of the fixed side flange 14.

In the case of the load measuring apparatus of the rolling bearing unit of the second example of the background art structure, when an axial load is applied between the wheel, not illustrated, and the knuckle 16, the outer side face of the knuckle 16 and the inner side face of the fixed side flange 17 strongly press the respective load sensors 20 from both faces thereof in an axial direction. Therefore, by totalizing measured values of the respective load sensors 20, the axial load applied between the wheel and the knuckle 16 can be calculated. Further, although not illustrated, JP-B-62-3365 (hereinafter, described as "Patent Reference 3") describes a method of calculating a revolution speed of a rolling member and measuring an axial load applied to a rolling bearing from a vibration frequency of an outer ring corresponding member a rigidity of which is partially reduced.

In the above-described case of the first example of the background art structure shown in Fig. 15, the load applied to the rolling bearing unit is measured by measuring a displacement between the outer ring 1 and the hub 2 in the diameter direction by the displacement sensor 11. However, a displacement amount in the diameter direction is small and therefore, in order to accurately calculate the load, the displacement sensor 11 having a high accuracy needs to be used. The noncontact type sensor having a high accuracy is expensive and therefore, it is an unavoidable that cost of a total of the rolling bearing unit having the load measuring apparatus is increased.

Further, in the above-described case of the second embodiment of the background art structure shown in Fig. 16, the load sensors 20 need to be provided by a number the same as that of the bolts 18 for fixedly supporting the outer ring 1a to the knuckle 16. Therefore, in addition to that the load sensor 20 per se is expensive, it is unavoidable that cost of the load measuring apparatus of the rolling bearing unit is considerably increased. Further, according to the method described in Patent Reference 3, it is necessary to reduce the rigidity of the outer ring corresponding member partially and there is a possibility that it is difficult to ensure a durability of the outer ring corresponding member.

Further, according to the rotation speed detecting apparatus for detecting rotation speeds of various rotating members used in the load measuring apparatus of the rolling bearing unit, when a rotational center of the member the rotation speed of which is to be detected and a geometrical center of an encoder do not coincide with each other, an accuracy of detecting the rotation speed is deteriorated. In order to prevent the accuracy of detecting the rotation speed from being deteriorated by such a cause, it is conceivable to eliminate an influence by a deviation of the two centers by summing together detecting signals of a pair of the rotation detecting sensors arranged at positions of two portions of the encoder on sides opposed to each other in the diameter direction. However, in that case, two pieces of the rotation detecting sensors are needed, by that amount, the cost and an installing space are increased thereby and therefore, there is also conceivable a case in which the apparatus is difficult to be adopted.

As a technology for removing a noise component having a comparatively low frequency, there is known an adaptive filter operated by an LMS algorism described in Haruo Hamada, "Fundamental of an adaptive filter (part 2)" proceeding of the Japan Acoustic Society, vol.45, No.9, (Corp.) Japan Acoustic Society, 1989, p.731-738 (hereinafter, described as "Nonpatent Reference 1"). Further, with regard to an outline of an adaptive filter, there have been known:

Chuo university, electric, electronic, information, conmtunication engineering department, Chao research lab., "What is adaptive filter", [online], [searched on August 29, Heisei 15], internet <URL: http://www.elect.chuo-u.ac.jp/chao/forB3/dsp/volterra/filter.htm 1> (hereinafter, described as "Nonpatent Reference 2"), The MathWorks, Inc., "Outline and application of adaptive filter", [online], [searched on August 29, Heisei 15], internet <URL:http://www.mathworks.ch/access/helpdesk/jhelp/toolbox/filte rdesign/adaptiv2.shtml> (hereinafter, described as "Nonpatent Reference 3"), The Mathworks, Inc., "Example of adaptive filter using LMS algorism", [online], [searched on August 29, Heisei 15], internet, <URL: http://www.mathworks.ch/access/helpdesk/jhelp/toolbox/filterdezi gn/adaptiv9.shtml> (hereinafter, described as "Nonpatent Reference 4") and the like. Further, also with regard to a synchronizing type filter which is a kind of an adaptive filter, there has been known, for example, Haruo Hamada, other 3 "Synchronizing type adaptive filter and active application to active noise/vibration control", proceeding of the Japan Acoustic Society, 3-5-13, (Corp.) Japan Acoustic Society, March, Heisei 4, p.515-516 (hereinafter, described as "Nonpatent Reference 5"). Further, with regard to a technology of suppressing vibration of an engine by a synchronizing type LMS algorism, it has been known by being described in Shigeki, Sato, other 4 "Development of active mount", automobile technology, (Corp.) The Society of Automobile Engineers of Japan, Vol. 53, No.2, February 1999, p. 62-66 (hereinafter described as "Nonpatent Reference 6". However, in the background art, the above-described adaptive filter is used centering on so-to-speak active noise control for reducing low frequency noise by emitting a sound wave having a phase inverse to that of low frequency noise. That is, in the background art, the adaptive filter is used only for reducing low frequency noise such that low frequency noise emitted from a duct of an air conditioner to a room is reduced, or exhaust sound or running sound at low frequency entering inside of a compartment of a passenger vehicle is reduced, further, external noise at a low frequency entering from an outside of a headphone is reduced or the like. The technology described in Nonpatent Reference 6 is aimed at restraint of vibration of an engine. In other words, with regard to the technology of the adaptive filter which has been known in the background art by being described in Nonpatent Reference 1 or the like, it has not been conceived at all to promote an accuracy of detecting a rotation speed by utilizing the encoder regardless of a whirling movement of the encoder. Further, it has not been particularly taken into consideration to promote the accuracy of detecting the rotation speed by other type of filter.

<Disclosure of the Invention>

In view of the above-described situation, it is an object of the invention to provide a rotation speed detecting apparatus and a load measuring apparatus of a rolling bearing unit capable of being constituted at low cost, without posing a problem in durability or an installing space, and capable of measuring a rotation speed of a rotating member while ensuring an accuracy needed for a control.

Preferably, it is an object thereof to provide a rotation speed detecting apparatus capable of measuring a rotation speed of the rotating member without producing a delay over time by being applied to a field of detecting a rotation speed which is quite different from an acoustic field or the like applied in the background art.

The object of the invention is achieved by the following constitution.

A rotation speed detecting apparatus of the invention comprises an encoder fixedly supported by a rotating member, rotated along with the rotating member and changing a characteristic thereof alternately in a circumferential direction, a rotation detecting sensor provided with a detecting portion thereof in a state of being opposed to a detected face of the encoder, and a calculating unit for calculating a rotation speed of the rotating member based on a detecting signal transmitted from the rotation detecting sensor and changed periodically.

Particularly, according to the rotation speed detecting apparatus of the invention, the calculating unit includes a filter circuit for removing an influence of a variation of the detecting signal of the rotation detecting sensor constituting an error in calculating the rotation speed of the rotating member {for example, owing to an incoincidence between a rotational center and a geometrical center of the encoder}.

As the filter circuit, preferably, an adaptive filter is used.

According to the rotation speed detecting apparatus of the invention constituted as described above, for example, even when the rotational center of the rotating member and the geometrical center of the encoder do not coincide with each other, the rotation speed of the rotating member can accurately be calculated. That is, even when the centers do not coincide with each other and the variation based on the incoincidence is produced in the detecting signal of the rotation detecting sensor, the variation can be canceled. Therefore, by accurately grasping various states based on the rotation speed of the rotating member, a swift and proper measure can be carried out.

Particularly, when the adaptive filter is used as the filter circuit, a delay of a signal processing in accordance with canceling the variation can be nullified and various controls utilizing the rotation speed can swiftly be carried out.

When the invention is embodied, preferably, an error component in the detecting signal constituting an object to be removed as the influence of the variation by the filter circuit is constituted by a rotation primary component of the encoder.

A variation width of the rotation primary component of the encoder is liable to be increased in comparison with other component and therefore, by canceling the variation of the component by the filter circuit, the accuracy of detecting the rotation speed of the rotating member can effectively be increased.

Further, as the filter circuit, other than the adaptive filter, one or a plurality of kinds of digital filters or analog filters, or a low pass filter, or a notch filter can respectively be used.

In a case of using the filter circuits, when a filter of a degree number fixed type for changing a cut off frequency in accordance with a rotation speed of the rotating member is used, the detecting signal can effectively be processed by the filter circuit even in a use in which the rotation speed of the rotating member is changed.

Further, when the invention using the adaptive filter and the filter circuit is embodied, preferably, a tap number of the adaptive filter is made to be equal to a number of pulses per one rotation of the encoder.

Further, as the adaptive filter, it is preferable to use the adaptive filter operated by a synchronizing type LMS algorism.

When constituted in this way, a number of times of calculation processings necessary for the detecting signal of the rotation detecting sensor at each pulse of the encoder is considerably reduced to be sufficiently able to process by a calculating unit (CPU) of low cost in which a calculation speed thereof is not particularly fast.

Further, preferably, an average value of a filter coefficient of the adaptive filter is calculated and a DC level of the detecting signal of the rotation detecting sensor is corrected based on the average value.

In this case, as the average value of the filter coefficients, it is preferable to use an average value of filter coefficients sampled at arbitrary two points present at equal intervals in the direction of rotating the encoder (positions on sides opposed each other by 180 degrees), or an average value of 4 points or more of filter coefficients constituting a plurality of combined data constituted by a combination of pairs of filter coefficients sampled at arbitrary two points present at equal intervals in the direction of rotating the encoder.

When constituted in this way, even in a case in which the adaptive filter operated by a synchronizing type LMS algorism is used, the adaptive filter prevents the DC level of the detecting signal of the rotation detecting sensor from being canceled and various states based on the rotation speed of the rotating member can accurately be grasped.

Further, preferably, the adaptive filter is arranged in parallel with a main signal path (main route) for transmitting the detecting signal of the rotation detecting sensor. Further, along therewith, an error component constituting an amount of the variation of the rotation detecting sensor calculated by the adaptive filter is subtracted at a downstream portion of the main signal path. Further, by such a constitution, an influence of the variation of the detecting signal of the rotation detecting sensor is removed.

When the adaptive filter is arranged in parallel with the main signal path in this way, by a constitution different from a constitution in which a filter is arranged (inserted) in series with the main signal path and a characteristic of the filter is made to be variable by some method which is generally used in a background art, the influence of the variation of the detecting signal of the rotation detecting sensor can easily and sufficiently be removed. Further, although in a case of a filter of a notch filter or the like inserted in series therewith, there is a possibility of producing a delay over time in a main signal, by arranging the filter in parallel therewith, there is not a concern of producing a delay over time in the main signal.

Further, preferably, as the adaptive filter, a digital filter or an analog filter operated by a steepest descent method is used. Further, further preferably, as the adaptive filter, a digital filter or an analog filter operated by an LMS (least squares mean) algorism (an operation rule minimizing a squares mean error based on the steepest descent method).

When the adaptive filter operated by the steepest descent method (further preferably, LMS algorism) is used, the adaptive filter can be finished in a state of minimizing the variation based on the incoincidence between the rotational center of the rotating member and the geometrical center of the encoder. Therefore, the error based on the variation can easily and sufficiently be reduced.

Further, preferably, the reference signal constituting the input of the adaptive filter (signal related to the variation of the output signal of the rotation detecting sensor based on whirling) is generated by itself by a processing circuit of the detecting signal of the rotation detecting sensor opposed to the encoder in a which a number of times of changes in the characteristic in one rotation has been known, or a processing circuit for calculating the rotation speed of the rotating member based on the detecting signal.

When constituted in this way, the reference signal can be generated at low cost and by saving a space. That is, in a case of an active noise control which is generally known as a use of an adaptive filter in a background art, a frequency and a waveform of external noise to be reduced are not necessarily known. Therefore, it is necessary to generate a reference signal for producing sound for canceling the external noise (sound having a magnitude the same as that of the external noise and a phase of a waveform deviated therefrom by 180 degrees) based on external noise collected by a microphone provided separately (producing the reference signal by a signal inputted from outside). In contrast thereto, in the case of the invention of using the adaptive filter as the filter circuit, by the adaptive filter, the variation signal of the detecting signal of the rotation detecting sensor based on whirling of the encoder is reduced. Further, the number of times of changes in the characteristic in one rotation of the encoder is previously known and therefore, by observing the number of pulses of one rotation of the encoder, without particularly providing a sensor for measuring whirling, the reference signal related to the variation can be generated. The refererice signal can be constituted by any waveform of a sine wave, a triangular waveform, a sawtooth wave, a rectangular wave, a pulse wave constituting one period by one rotation of the encoder.

Further, preferably, with regard to the variation of the detecting signal of the rotation detecting sensor, a low pass filter is provided frontward or rearward of the adaptive filter for averaging a second variation based on a cause different from that of the variation based on whirling of the encoder (so-to-speak accumulated pitch error) constituting the variation the influence of which is removed by the adaptive filter and having a period shorter than that of the variation (first variation) based on the whirling.

In the variation of the detecting signal of the rotation detecting sensor in accordance with rotation of the encoder, other than the variation (first variation) (of a low frequency wave) having a comparatively long period based on the whirling, there is a variation (second variation) (of a high frequency wave) having a comparatively short period by a pitch error of a change in the characteristic in the circumferential direction. It is difficult to reduce the variation of the high frequency wave by the adaptive filter. However, the variation of the high frequency wave can be corrected by a low pass filter of an averaging filter or the like for executing an averaging processing of a moving average or the like. Therefore, when the low pass filter of the average filter or the like is provided frontward or rearward of the adaptive filter as described above, not only the variation (first variation) of the detecting signal of the rotation detecting sensor based on whirling of the encoder referred to as so-to-speak accumulated pitch error but also the variation (second variation) of the detecting signal of the rotation detecting sensor based on the pitch error of the change in the characteristic of the encoder can be reduced.

Further, when the invention using the adaptive filter as the filter circuit is embodied, preferably, the rotating member fixedly supporting the encoder is constituted by a retainer provided between a pair of bearing rings constituting a rolling bearing unit and rotated in accordance with revolution of rolling members retained in a plurality of pockets.

The variation of the detecting signal of the rotation speed detecting sensor based on whirling the encoder is produced owing to the incoincidence between the rotational center and the geometrical center of the encoder. Further, the incoincidence is produced also by an integrating error or the like. However, the incoincidence between the two centers based on the integrating error can be restrained to a practically unproblematic degree by increasing the integrating accuracy.

However, in a case in which the encoder is supported by the retainer, even when geometrical centers of the retainer and the encoder are made to coincide with each other completely, the incoincidence between the rotational center and the geometrical center of the encoder is produced. The reason is that as described above, a clearance is present between a rolling face of each rolling member and an inner face of the pocket of the retainer.

Therefore, when the rotation speed of the retainer is measured by utilizing the encoder fixedly supported by the retainer, it is important to deal with the variation of the detecting signal of the rotation detecting sensor based on the incoincidence between the rotational center and the geometrical center of the encoder.

Further, particularly, when the detected face is one side face in an axial direction of the encoder, it is important to embody the invention of using the adaptive filter as the filter circuit.

In a case in which the encoder is fixedly supported by a portion of the retainer and in a case in which the geometrical center and the rotational center of the encoder do not coincide with each other, even when the detected face of the encoder is constituted by any face (regardless of a peripheral face, the one side face in the axial direction), the detecting signal of the rotation detecting sensor is varied based on the incoincidence. However, when the encoder and a detecting portion of the rotation speed detecting apparatus are arranged at inside of a limited space in the rolling bearing, a degree of freedom of design is increased by constituting the detected face by the one side face in the axial direction of the encoder.

Further, the embodiment of the invention using the adaptive filter as the filter circuit, preferably, a load measuring apparatus of a rolling bearing unit is conceivable.

The load measuring apparatus of the rolling bearing unit is provided with a stationary ring, a rotating ring, a plurality of rolling members, a pair of rotation speed detecting apparatus and a calculating unit.

The stationary ring among is not rotated even in being used.

Further, the rotating ring is arranged concentrically with the stationary ring and is rotated in being used.

Further, the respective rolling members are rollably provided between stationary side tracks and rotating side tracks formed by respective two rows at portions of the stationary ring and the rotating ring opposed to each other by respective pluralities of pieces thereof and making directions of contact angles inverse to each other between the two rows.

Further, the rotation speed detecting apparatus is for detecting the rotation speed of the pair of retainers retaining the two rows of the rolling members.

Further, the calculating unit calculates the load between the stationary ring and the rotating ring based on the rotation speeds of the pair of retainers detected by the respective rotation speed detecting apparatus.

When the invention of using the adaptive filter as the filter circuit is applied to the load measuring apparatus of the rolling bearing unit, the above-described respective rotation speed detecting apparatus are constituted by the above-described structure.

Further preferably, the rotating ring is constituted by a hub rotated along with a wheel in a state of being fixed to the wheel of an automobile.

<Brief Description of the Drawings>

Fig. 1 is a sectional view of a rolling bearing unit integrated with a rotation detecting apparatus for measuring a load showing a first embodiment of the invention,

Fig. 2 is a view enlarging portion A of Fig.1,

Fig. 3 is a schematic view taking out a retainer and a rolling member, an encoder, a rotation detecting sensor to show in a state of being viewed from an upper side of Fig.2,

Fig. 4 is a schematic view of a rolling bearing unit for explaining reason of capable of measuring a load based on a rotation speed,

Fig. 5 is a block diagram showing a circuit for reducing a variation in an output signal of a rotation speed detecting sensor based on whirling of the retainer by an adaptive filter.

Fig. 6 is a schematic view showing a retainer and an encoder from side directions of Figs.1 through 3 for explaining reason of varying the output signal of the rotation speed detecting sensor based on whirling of the retainer,

Fig. 7 is a diagram showing a state of varying a signal indicating a rotation speed calculated from the output signal of the rotation speed sensor based on whirling of the retainer and an error in a magnetizing pitch,

Fig. 8 is a diagram showing a state of reducing a variation of a signal indicating the rotation speed calculated from the output signal of the rotation speed sensor by an adaptive filter,

Fig. 9 is a diagram showing a situation of varying a signal indicating a rotation speed when an adaptive filter is operated by a synchronizing type LMS algorism and a correction with regard to a DC level is not carried out for explaining a necessity of a second embodiment of the invention,

Fig. 10 is a diagram similar to Fig. 5 showing the second embodiment of the invention,

Fig. 11 is a graph showing a state of sampling a filter coefficient for carrying out the correction with regard to the DC level,

Fig. 12 is a diagram showing a situation of varying a signal indicating a rotation speed when an adaptive filter is operated by a synchronizing type LMS algorism and the correction with regard to the DC level is carried out in order to show an effect of the second embodiment,

Fig. 13 is a flowchart showing operation of a low pass filter used in a third embodiment of the invention,

Fig. 14 is a flowchart showing operation of a notch filter used in a fourth embodiment thereof,

Fig. 15 is a sectional view of a rolling bearing unit integrated with a sensor for measuring a radial load which has been known in a background art,

Fig. 16 is a sectional view of a rolling bearing unit integrated with a sensor for measuring an axial load which has been known in a background art.

Further, in notations in the drawings, notations 1, 1a designate outer rings, notations 2, 2a designate hubs, notations 3, 3a designate rotating side flanges, numeral 4 designates a hub main body, numeral 5 designates a nut, numeral 6 designates an inner ring, numeral 7 designates an outer ring track, numeral 8 designates an inner ring track, notations 9a, 9b designate rolling members, notations 10, 10a designate attaching holes, numeral 11 designates a displacement sensor, numeral 12 designates a sensor ring, numeral 13 designates a sensor rotor, numeral 14 designates a cover, notations 15, 15a designate rotation speed detecting sensors, numeral 16 designates a knuckle, numeral 17 designates a fixed side flange, numeral 18 designates a bolt, numeral 19 designates a screw hole, numeral 20 designates a load sensor, notations 21a, 21b designate retainers, numeral 22 designates a sensor unit, numeral 23 designates a front end portion, notations 24a, 24b designate revolution speed detecting sensors, numeral 25 designates rim portion, notations 26a, 26b designate revolution speed detecting encoders, numeral 27 designates a rotation speed detecting encoder, numeral 28 designates an adaptive filter.

<Best Mode for Carrying Out the Invention>

A detailed explanation will be given of a rotation speed detecting apparatus and a load measuring apparatus of a rolling bearing unit according to respective embodiments of the invention in reference to the drawings as follows.

(First Embodiment)

Figs .1 through 8 show a first embodiment of the invention. The embodiment is shown when the invention is applied to a load measuring apparatus of a rolling bearing unit for measuring a load (radial load and axial load) applied to a rolling bearing unit for supporting a driven wheel of an automobile (front wheels of FR vehicle, RR vehicle, front wheel of MD vehicle, rear wheel of FF vehicle) . Constitution and operation of the rolling bearing of the rolling bearing unit portion therein are similar to those of the above-described background art structure shown in Fig. 15 and therefore, equivalent portions are attached with same notations to omit or simplify a duplicated explanation and an explanation will be given centering on a characterizing operation of the embodiment as follows.

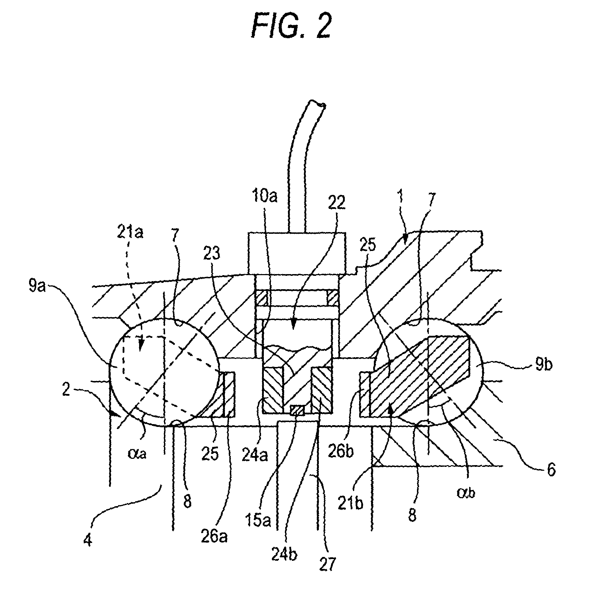

The outer peripheral face of the hub 2 constituting the rotating ring is formed with the inner ring tracks 8, 8 of the double row angular type respectively constituting rotating side tracks. Further, the inner peripheral face of the outer ring 1 constituting the stationary ring is formed with the outer ring tracks 7, 7 of the double row angular type respectively constituting the stationary side tracks. Further, the hub 2 is rotatably supported by the inner diameter side of the outer ring 1 by rollably supporting the rolling members (balls) 9a, 9b between the inner tracks 8, 8 of the double row angular type of the hub 2 and the outer ring tracks 7, 7 of the double angular type of the outer ring 1 in a state of dividing the respective rolling members (balls) 9a, 9b in double rows (2 rows) and maintaining the rolling members by the retainers 21a, 21b by respective pluralities of pieces thereof at respective rows. Under the state, the rolling members 9a, 9b of the respective rows are provided with contact angles $\alpha_a$, $\beta_b$ (Fig. 2) in directions inverse to each other and having the same size to constitute a double row angular type ball bearing of a back face integrating type. The respective rows of rolling members 9a, 9b are applied with sufficient preloads to a degree by which the rolling members are not lost by an axial load applied in being used. In using the rolling bearing unit, the outer ring 1 is fixedly supported by a suspension and a disk for braking and a wheel portion of a wheel is fixedly supported by the rotating side flange 3 of the hub 2.

The attaching hole 10a is formed in the state of penetrating the outer ring 1 at the middle portion in the axial direction of the outer ring 1 and at the portion between the double rows of outer ring tracks 7, 7 constituting the above-described rolling bearing unit. Further, the sensor unit 22 is inserted to the attaching hole 10a from an outer side to an inner side in the diameter direction of the outer ring 1 and the front end portion 23 of the sensor unit 22 is projected from an inner peripheral face of the outer ring 1. The front end portion 23 is provided with a pair of the revolution speed detecting sensors 24a, 24b respectively constituting the rotation detecting sensors and a single piece of the rotation speed detecting sensor 15a.

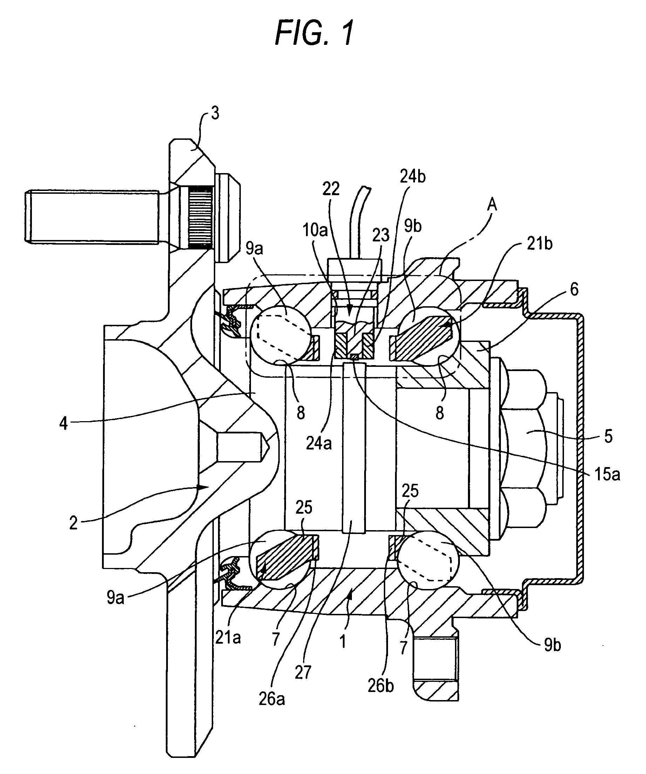

The respective rotating speed detecting sensors 24a, 24b thereamong are for measuring revolution speeds of the rolling members 9a, 9b arranged in the double rows. The respective revolution speed detecting sensors 24a, 24b arrange respective detecting faces thereof at two side face in the axial direction of the hub 2 (left and right direction of Figs.1 through 2) in the front end portion 23. In the case of the embodiment, the respective rotating speed detecting sensors 24a, 24b detect the revolution speeds of the respective rolling members 9a, 9b arranged in the double rows as rotation speeds of the respective retainers 21a, 21b. For that purpose, in the case of the embodiment, the rim portions 25, 25 constituting the respective retainers 21a, 21b are arranged on sides opposed to each other. Further, the revolution speed detecting encoders 26a, 26b respectively constituting a shape of a circular ring are attached to and supported by faces of the respective rim portions 25, 25 opposed to each other over entire peripheries thereof. Characteristics of detected faces of the respective encoders 26a, 26b are changed alternately and at equal intervals in a circumferential direction to thereby make the rotation speeds of the respective retainers 21a, 21b detectable by the revolution speed detecting sensors 24a, 24b.

For that purpose, the detecting faces of the respective revolution speed detecting sensors 24a, 24b are made to be proximately opposed to faces opposed to each other constituting detected faces of the respective revolution speed detecting encoders 26a, 26b. Further, it is preferable to constitute distances between the detected faces of the respective revolution speed detecting encoders 26a, 26b and the detecting faces of the revolution speed detecting sensors 24a, 24b (detection clearance) to be larger a pocket clearance constituting a clearance between inner faces of pockets of the respective retainers 21a, 21b and rolling faces of the respective rolling members 9a, 9b and equal to or smaller than 2 mm. When the detection clearance becomes equal to or smaller than the pocket clearance, in a case in which the respective retainers 21a, 21b are displaced by an amount of the pocket clearance, there is brought about a possibility of rubbing the detected face and the detecting face and therefore, the case is not preferable. On the contrary, when the detection clearance exceeds 2 mm, it is difficult to accurately measure rotation of the respective revolting speed detecting encoders 26a, 26b by the respective revolution speed detecting sensors 24a, 24b.

On the other hand, the rotation speed detecting sensor 15a is for measuring the rotation speed of the hub 2 constituting the rotating ring and a detecting face thereof is arranged on a front end face of the front end portion 23, that is, an inner end face thereof in the diameter direction of the outer ring 1. Further, the rotation speed encoder 27 in a cylindrical shape is outwardly fitted to be fixed at a middle portion of the hub 2 and between the inner tracks 8, 8 of the double rows. A detecting face of the rotation speed detecting sensor 15a is made to be opposed to an outer peripheral face of the rotation speed detecting encoder 27 constituting a detected face. A characteristic of the detected face of the rotation speed detecting encoder 27 is changed alternately and at equal intervals in a circumferential direction to make the rotation speed of the hub 2 detectable by the rotation speed detecting sensor 15a. Also a measurement clearance between an outer peripheral face of the rotation speed detecting encoder 27 and the detecting face of the rotation speed detecting sensor 15a is restrained to be equal to or smaller than 2 mm.

Further, as the respective encoders 26a, 26b, 27 having various structures utilized for detecting a rotation speed of a wheel can be used in order to provide a signal for controlling ABS or TCS in the background art. For example, the respective encoders 26a, 26b, 27 made of multiple magnets arranging N poles and S poles alternately and at equal intervals at the detected face (side face or outer peripheral face) can preferably be used. Incidentally, an encoder simply made of a magnetic material or an encoder in which an optical characteristic is changed alternately and at equal intervals over a circumferential direction (by combining with a rotation speed detecting sensor of an optical type) can be used.

In the case of the embodiment, as the respective revolution speed detecting encoders 26a, 26b, there is used a permanent magnet in a shape of a circular ring in which side faces thereof constituting a detected face is arranged with S poles and N poles alternately and at equal intervals. The respective revolution speed detecting encoders 25a, 26b are coupled to fix to side faces of the rim portions 25, 25 of the respective retainers 21a, 21b produced separately by adhering or molded by insert molding by setting the revolution speed detecting encoders 26a, 26b at inside of a cavity when the respective retainers 21a, 21b are molded by injection molding. It is selected which of the methods is adopted in accordance with cost a required coupling strength or the like.

Further, rotation detecting sensors for a magnetic type can preferably be used as the respective revolution speed detecting sensors 24a, 24b and the rotation speed detecting sensor 14a all of which are sensors for detecting the rotation speed. Further, as the rotation detecting sensor of the magnetic type, an active type integrated with a magnetic detecting element of a hole element, a hole IC, a magentoresistive element (MR element, GMR element), MI element or the like can preferably be used. In order to constitute the rotation detecting sensor of the active type integrated with the magnetic detecting element, for example, one side face of the magnetic detecting element is butted to one end face in a magnetizing direction of a permanent magnet directly or by way of a stator made of a magnetic material (when an encoder made of a magnetic material is used), and other side face of the magnetic detecting element is made to be opposed to the detected faces of the respective encoders 26a, 26b, 27 directly or by way of a stator made of a magnetic material. Further, in the case of the embodiment, the encoder made of the permanent magnet on the side of the sensor is not needed.

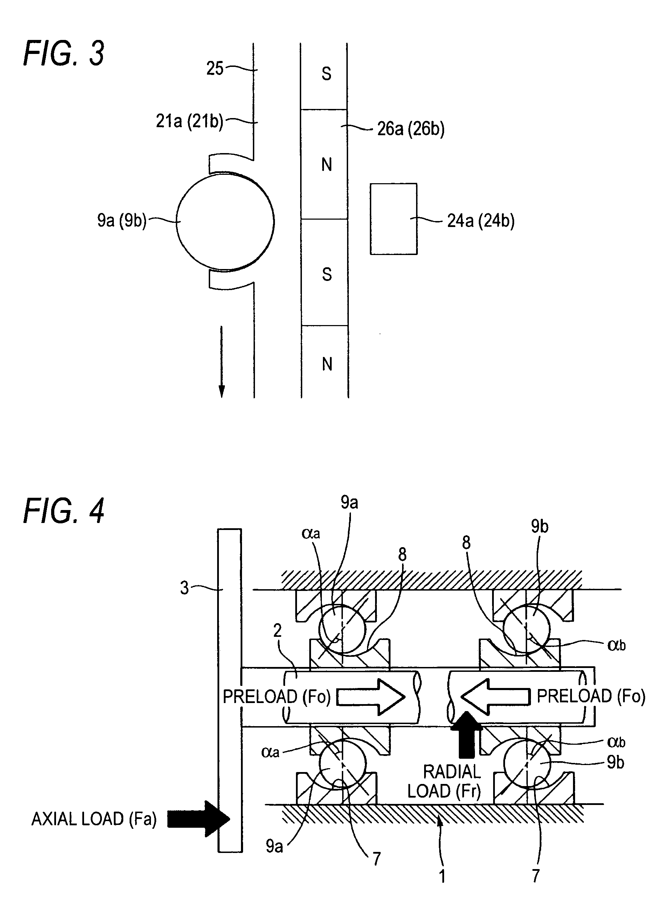

In the case of the load measuring apparatus of the rolling bearing unit according to the invention, detecting signals of the respective sensors 24a, 24b, 15a are inputted to a calculating unit, not illustrated. Further, the calculating unit calculates one or both the radial load and the axial load applied between the outer ring 1 and the hub 2 based on the detecting signals transmitted from the respective sensors 24a, 24b, 15a. For example, when the radial load is calculated, the calculating unit calculates a sum of revolution speeds of the rolling members 9a, 9b of the respective loads detected by the revolution speed detecting sensors 24a, 24b. Further, the calculating unit calculates the radial load based on a ratio of the sum to the rotation speed of the hub 2 detected by the rotation speed detecting sensor 15a. Further, when the axial load is calculated, the calculating unit calculates a difference between the revolution speeds of the rolling members 9a, 9b of the respective rows detected by the revolution speed detecting sensors 24a, 24b. Further, the calculating unit calculates the axial load based on a ratio of the difference to the rotation speed of the hub 2 detected by the rotation speed detecting sensor 15a. An explanation will be given in this respect in reference to Fig. 4. Further, the following explanation will be given by assuming that the contact angles $\alpha_a$, $\alpha_b$ of the rolling members 9a, 9b of the respective loads are the same as each other in a state in which the axial load $F_a$ is not applied.

Fig. 4 shows a state of operating a load by schematizing the rolling bearing unit for supporting the wheel shown in Fig. 1. Preloads $F_0$, $F_0$ are applied to the rolling members 9a, 9b arranged in the double rows between double rows of the inner ring tracks 8, 8, and double rows of the outer ring tracks 7, 7. Further, the rolling bearing unit is applied with the radial load $F_r$ by the weight of the vehicle body or the like when used. Further, the axial load $F_a$ is applied by a centrifugal force applied in turning to run or the like. All of the preloads $F_0$, $F_0$, the radial load $F_r$, the axial load $F_a$ effect influences on the contact angles $\alpha$ ($\alpha_a$, $\alpha_b$) of the respective rolling members 9a, 9b. Further, when the contact angles $\alpha_a$, $\alpha_b$ are changed, the revolution speed $n_c$ of the respective rolling members 9a, 9b is changed. When a pitch circle diameter of the respective rolling members 9a, 9b is designated by notation D, a diameter of the respective rolling members 9a, 9b is designated by notation d, the rotation speed of the hub 2 provided with the respective inner ring tracks 8, 8 is designated by notation $n_i$, and the rotation speed of the outer ring 1 provided with the respective outer ring tracks 7, 7 is designated by notation $n_o$, the revolution speed $n_c$ is expressed by Equation (1) shown below.

$$n_c = \{1 - (d \cdot \cos \alpha / D) \cdot (n_i/2)\} + \{1 + (d \cdot \cos \alpha / D) \cdot (n_o/2)\} \dots (1)$$

As is apparent from Equation (1), the revolution speed $n_c$ of the respective rolling members 9a, 9b is changed in accordance with a change in the contact angle $\alpha$ ($\alpha_a$, $\alpha_b$) of the respective rolling members 9a, 9b, and as described above, the contact angles $\alpha_a$, $\alpha_b$ are changed in accordance with the radial load $F_r$ and the axial load $F_a$. Therefore, the revolution speed $n_c$ is changed in accordance with the radial load $F_r$ and the axial load $F_a$. Specifically, with regard to the radial load $F_r$, the larger the radial load $F_r$, the slower the revolution speed $n_c$ since the hub 2 is rotated and the outer ring 1 is not rotated. Further, with regard to the axial load, the revolution speed of the row for supporting the axial load becomes fast and the revolution speed of the row which does not support the axial load becomes slow. Therefore, the radial load $F_r$ and the axial load $F_a$ are calculated based on the revolution speed $n_c$.

However, the contact angle $\alpha$ related to a change of the revolution speed $n_c$ is changed not only by the radial load $F_r$ and the axial load $F_a$ while being related to each other but also changed by the preloads $F_0$, $F_0$. Further, the revolution speed $n_c$ is changed in proportion to the rotation speed $n_1$ of the hub 2. Therefore, the revolution speed $n_c$ cannot accurately be calculated unless all of the axial load $F_a$, the preloads $F_0$, $F_0$, the rotation speed $n_1$ are relatedly taken into consideration. The preloads $F_0$, $F_0$ thereamong are not changed in accordance with an operating state and therefore, it is easy to exclude the influence by initial setting or the like. In contrast thereto, the radial load $F_r$, the axial load $F_a$, the rotation speed $n_1$ of the hub 2 are always changed in accordance with the operating state and therefore, the influence cannot be excluded by the initial setting or the like.

In view of the above-descried situation, in the case of the embodiment, as described above, when the radial load is calculated, by calculating the sum of the revolution speeds of the rolling members 9a, 9b of the respective rows detected by the respective revolution speed detecting sensors 24a, 24b, the influence of the axial load $F_a$ is reduced. Further, when the axial load is calculated, by calculating the difference between the revolution speeds of the rolling members 9a, 9b of the respective rows, the influence of the radial load $F_r$ is reduced. Further, in any of the cases, by calculating the radial load $F_r$ or the axial load $F_a$ based on the ratio of the sum or the difference to the rotation speed $n_1$ of the hub 2 detected by the rotation speed detecting sensor 15a, the influence of the rotation speed $n_i$ of the hub 2 is excluded. However, when the axial load $F_a$ is calculated based on the ratio of the rotation speeds of the rolling members 9a, 9b of the respective loads, the rotation speed of the hub 2 is not necessarily needed.

Further, although there are variously present methods for calculating one or both of load(s) of the radial load and the axial load based on signals of the respective revolution speed detecting sensors 24a, 24b, the methods are not related to the gist of the invention and therefore, a detailed explanation thereof will be omitted.

However, in calculating any load by any method, it is important to accurately calculate the revolution speeds of the rolling members 9a, 9b of the respective rows based on the detecting signals of the respective revolution speed detecting sensors 24a, 24b for increasing the accuracy of measuring the load.

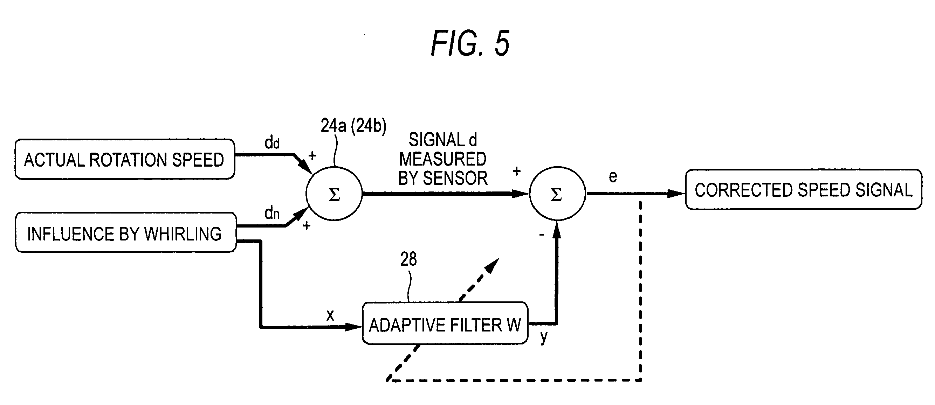

In contrast thereto, the detecting signals of the respective revolution speed detecting sensors 24a, 24b (signals indicating the revolution speeds based thereon) include a variation having a comparatively high frequency as described above based on an error of a tnagnetizing pitch (pitch between an S pole and an N pole contiguous to each other in the circumferential direction) of the detected face and a variation having a comparatively low frequency as described above in accordance with whirling movements of the retainers 21a, 21b. When the variations are not processed (reduced), the revolution speeds of the rolling members 9a, 9b of the respective rows cannot accurately be calculated and therefore, accuracies of measuring the radial load or the axial load are deteriorated. Hence, in the case of the embodiment, by the adaptive filter as shown by Fig. 5, the variation having the comparatively low frequency based on the whirling movement is reduced, further, by a low pass filter of an averaging filter or the like, not illustrated, the variation having the comparatively high frequency based on the error of the magnetizing pitch is reduced.

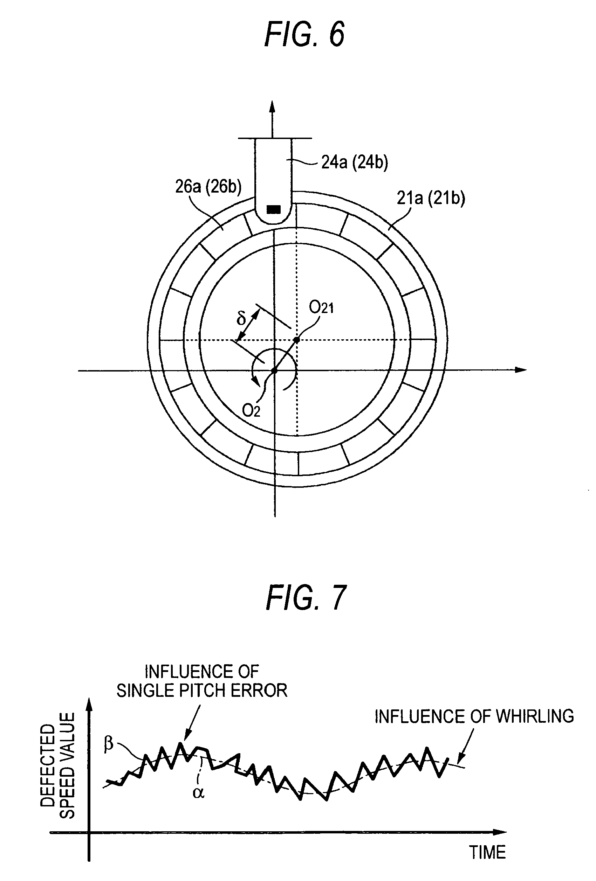

First, an explanation will be given of reason of producing two kinds of the variations in reference to Figs. 6 through 7. There is a clearance between the inner face of the pocket of the retainer 21a (21b) retaining the revolution speed detecting encoder 26a (26b) (or having a function as an encoder by itself) and the rolling face of the respective rolling members 9a (9b) in view of a necessity of retaining the respective rolling members 9a (9b) rollably. Therefore, even when accuracies of integrating respective constituent members are increased as much as possible, in operating the rolling bearing unit, there is a possibility that a center (rotational center of the hub 2) $O_2$ of a pitch circle of the respective rolling members 9a (9b) and a rotational center $O_{21}$ of the retainer 21a (21b) are deviated from each other by an amount of $\delta$ as is exaggeratingly shown in Fig. 6. Further, based on the deviation, the revolution speed detecting encoder 26a (26b) carries out a whirling movement at a surrounding of the rotational center $O_{21}$. As a result of the whirling movement, the detected face of the revolution speed detecting encoder 26a (26b) is provided with a moving speed other than in the rotational direction. Further, the moving speed in other than the rotational direction, for example, a moving speed in a left and right direction of Fig. 6 is added and reduced to and from a moving speed in the rotational direction. On the other hand, the revolution speed detecting sensor 24a (24b) detects the revolution speed of the respective rolling members 9a (9b) based on the moving speed of the detected face of the revolution speed detecting encoder 26a (26b) and therefore, an eccentricity by the amount of $\delta$ effects an influence on the detecting signal of the revolution speed detecting sensor 24a (24b) the detecting face of which is made to be opposed to the side face of the revolution speed detecting encoder 26a (26b).

When the detecting face of the revolution speed detecting sensor 24a (24b) is made to be opposed to the side face of the revolution speed detecting encoder 26a (26b), the detecting signal (signal indicating the revolution speed based thereon) of the revolution speed detecting sensor 24a (24b) is sinusoidally changed as shown by a chain line α of Fig. 7. That is, even when the revolution speed of the respective rolling members 9a (9b) is constant, the revolution speed indicated by the output signal of the revolution speed detecting sensor 24a (24b) is sinusoidally changed as shown by the chain line α. Specifically, when the moving speed in the left and right direction of Fig. 6 is added to the moving speed in the rotational direction, the output signal becomes a signal in correspondence with a speed faster than the actual revolution speed. Conversely, when the moving speed in the left and right direction is subtracted from the moving speed in the rotational direction, the output signal becomes a signal in correspondence with a speed slower than the actual revolution speed. Although Fig. 6 draws the eccentricity amount δ more exaggeratingly than in the actual case, when the radial load $F_r$ and the actual load $F_a$ applied to the rolling bearing unit are further accurately calculated in order to further strictly carry out a control for, for example, stabilizing the vehicle, an error in accordance with the eccentricity needs to be resolved.

Further, although the pitch between the S pole and the N pole aligned at a side face of the revolution speed detecting encoder 26a (26b) is to stay to be the same inherently, owing to a magnetizing error or the like brought about in fabrication, there is case in which the pitches differ from each other although a difference therebetween is small. Further, based on the error, the detecting signal of the revolution speed detecting sensor 24a (24b) is varied. A period of the variation based on the error of the magnetizing pitch is far shorter than a period of the variation based on the whirling movement. For example, when a characteristic (a repetition of S pole and N pole) of the side face (detected face) of the revolution speed detecting encoder 26a (26b) is changed by 60 times over the total periphery of the detected face, the period of the variation based on the error of the magnetizing pitch becomes about 1/60 of the period of variation based on the whirling movement.

The detecting signal (signal indicating the revolution speed based thereon) outputted from the revolution speed detecting encoder 26a (26b) is as shown by a bold line β in Fig. 7 constituted by adding (superposing) two kinds of variations. In order to accurately calculate the radial load $F_r$ and the axial load $F_a$, the two kinds of variations need to be reduced. Hence, in the case of the embodiment, the variation having the comparatively low frequency in accordance with the whirling movement is reduced by the adaptive filter 28 shown in Fig. 5 and the variation having the comparatively high frequency in accordance with an error of the magnetizing pitch is reduced by a low pass filter of an averaging filter or the like, not illustrated. Further, as the adaptive algorism, an LMS (least squares mean) algorism (an operation rule minimizing a squares mean error based on the steepest descent method) using an FIR filter, mentioned later, as the adaptive filter is preferable.

First, an explanation will be given of a reduction in the variation having the low frequency by the adaptive filter shown in Fig. 5. A speed of displacing the revolution speed detecting encoder 26a (26b) at a portion thereof to which the detecting portion of the revolution speed detecting sensor 24a (24b) is opposed is constituted by superposing an actual rotation speed $d_d$ and an amount $d_n$ of varying an apparent speed of a rotation primary component by whirling based on an eccentricity by the amount of δ. Therefore, an output signal d of the revolution speed detecting sensor 24a (24b) becomes a signal indicating a speed of adding the actual rotation speed $d_d$ and the variation amount $d_n$ (d = $d_d$ + $d_n$). When the variation amount $d_n$ is subtracted (reduced) from the output signal d by the adaptive filter 28, the actual rotation speed $d_d$ is calculated.

On the other hand, in order to operate the adaptive filter 28, a reference signal x having a correlation with the variation amount $d_n$ based on whirling becomes necessary. When the reference signal x can be obtained, the adaptive filter 28 forms an FIR (finite impulse response) filter (filter having finite impulse response time = filter nullifying impulse response in finite time) having a characteristic the same as a transfer characteristic of an actual signal flow "$d_n \rightarrow$ d" by self learning. Further, when a cancel signal y {= y (k), mentioned later} provided as a result of calculation by the adaptive filter 28 is subtracted from the output signal d of the revolution speed detecting sensor 24a (24b), the subtraction becomes equivalent to that the variation amount $d_n$ by the whirling is removed from the output signal d of the revolution speed detecting sensor 24a (24b) (d - $d_n$). When the variation amount $d_n$ is removed in this way, the adaptive filter 28 does not filter the output signal d transmitted on a main route of signal (upper half portion of Fig. 5) but calculates the cancel signal y for removing the variation amount $d_n$ based on the reference signal x transmitted on a sub route (lower half portion of Fig. 5). Further, the cancel signal y is only subtracted from the output signal d constituting the main route and therefore, the response of the output signal d is not delayed.

In the case of the embodiment, the reference signal x is generated by itself by a circuit of processing the output signal of the revolution speed detecting sensor 24a (24b) opposed to the revolution speed detecting encoder 26a (26b) based on a number of times of a change in the characteristic during one rotation of the revolution speed detecting encoder 26a (26b), or a processing circuit for calculating the revolution speed of the respective rolling members 9a (9b) based on the detecting signal . Therefore, cost required for generating the reference signal x can be reduced. That is, when a structure of an active noise control which has been known as a use of the adaptive filter in the background art is applied to a structure for accurately calculating the revolution speed of the respective rolling member 9a (9b) as it is, whirling of the revolution speed detecting encoder 26a (26b) is detected by a separately provided sensor of a displacement sensor, a rotation speed sensor or the like, and a detecting signal of the sensor is used as the reference signal x of the adaptive filter 28. Naturally, the invention can also be embodied by such a structure, cost and an installing space are needed by an amount of providing a sensor separately.

In contrast thereto, in the case of the embodiment, the reference signal x is obtained without using the detecting signal of the sensor provided separately in this way, by the adaptive filter 28, the variation amount $d_n$ of the output signal d of the revolution speed detecting sensor 24a (24b) based on whirling of the revolution speed detecting encoder 26a (26b) is reduced. That is, the number of times (number of S poles and N poles) of changing the characteristic during one rotation of the revolution speed detecting encoder 26a (26b) is previously known. Therefore, by observing a number of pulses by one rotation of the revolution speed detecting encoder 26a (26b), without particularly providing separately a sensor of a displacement sensor, a rotation speed sensor or the like, the reference signal x having the correlation with the variation $d_n$ can be generated. Specifically, the influence of whirling of the revolution speed detecting encoder 26a (26b) is constituted by a waveform having a main component by a primary component of rotation thereof, for example, when the revolution speed detecting encoder 26a (26b) is for 60 pulses per rotation, the waveform can be generated by itself as a sine wave, a triangular wave, a sawtooth wave, a rectangular wave, a pulse wave or the like constituting one period by 60 data.

The waveform of the reference signal x can also be generated by a processing circuit (CPU) for calculating the revolution speed of the respective rolling members 9a (9b) and can also be generated by an electronic circuit portion (IC) attached to the revolution speed detecting sensor 24a (24b). At any rate, the cancel signal y calculated based on the obtained reference signal x is subtracted from the output signal d of the revolution speed detecting sensor 24a (24b) to calculate a modified signal e {= e (k), mentioned later} indicating the actual rotation speed $d_d$. The modified signal e calculated in this way is transmitted to a processing circuit for calculating the revolution speed of the respective rolling members 9a (9b) to be utilized for calculating the revolution speed, further, utilized also as information learnt by the adaptive filter 28 by itself.

Further, a processing for providing the modified signal e by calculating the cancel signal y at the portion of the adaptive filter 28 and subtracting the cancel signal y from the output signal d of the revolution speed detecting sensor 24a (24b) is executed based on Equations (2) through (4) shown below.

$$y(k) = \sum_{i=0}^{N-1} w_k(i) \cdot x(k-i) \quad \ldots \quad (2)$$

$$e(k) = d(k) - y(k) \ldots \quad (3)$$

$$w_{k+1}(i) = w_k(i) + 2\mu \cdot e(k) \cdot x(k-i) \quad \ldots \quad (4)$$

In Equations (2) (3) (4), notation k designates a data number in time sequence, notation N designates a tap number of an FIR filter as the adaptive filter 28. Further, notation w designates a filter coefficient of the FIR filter, notation $w_k$ designates a filter coefficient used when k-th data is processed, notation $w_{k+1}$ designates a filter used when a successive data sequence ((k+1) -th) is processed, respectively. That is, in the case of the embodiment, the FIR filter becomes an adaptive filter successively properly updating the filter coefficient by Equation (4). Null may substitute for the filter coefficient $W_k$ used first in starting the operation since the filter coefficient is adapted by itself when the operation is started, however, a desired filter characteristic may previously be calculated and a value thereof may substitute therefor. Further, a filter coefficient finally used in a preceding processing may be stored to storing means of EEPROM or the like and may be used when restarting.

Further, notation $\mu$ in Equation (4) is a value for determining an updating amount when the filter coefficient is made to be proper by itself referred to as step parameter, and normally becomes a value of about 0.01 through 0.001, however, actually, the value can be set by investigating acceptability of adaptive operation beforehand, or may successively be updated by using Equation (5) shown below.

$$\mu = \frac{\alpha}{\sum_{i=0}^{N-1} x^2(k-i)} \quad \ldots \quad (5)$$

Further, also α in Equation (5) becomes a parameter for determining an updating amount for making the filter coefficient proper by itself, α may fall in a range of 0 < α < 1 and α is set more easily than μ, mentioned above. Further, in the case of the embodiment, the reference signal x is generated by itself and therefore, a value of a denominator in Equation (5) is known and an optimum value of μ can also be calculated beforehand. From a view point of reducing a calculation amount, it is preferable that μ is previously calculated by Equation (5) and the filter coefficient is made to be proper by itself by Equation (4) by constituting a constant by μ.

As described above, a modified signal e indicating the actual rotation speed $d_d$ is calculated by subtracting the cancel signal y calculated by the adaptive filter 28 from the output signal d of the revolution speed detecting sensor 24a (29b). Further, based on the modified signal e calculated in this way, the revolution speed of the respective rolling members 9a (9b) can accurately be calculated. Further, in an actual case, in the output signal d of the revolution speed detecting sensor 24a (24b), there is present a second variation based on the pitch error having a period shorter than that of the variation based on whirling of the revolution speed detecting sensor 24a (24b). Hence, by providing a low pass filter of an averaging filter or the like for averaging the second variation before or after the adaptive filter 28, despite the second variation, the revolution speed of the respective rolling members 9a (9b) is made to be calculated accurately. Structure and operation of a low pass filter of an average filter or the like for restraining the variation having the high frequency is well known in the background art and therefore, a detailed explanation thereof will be omitted.

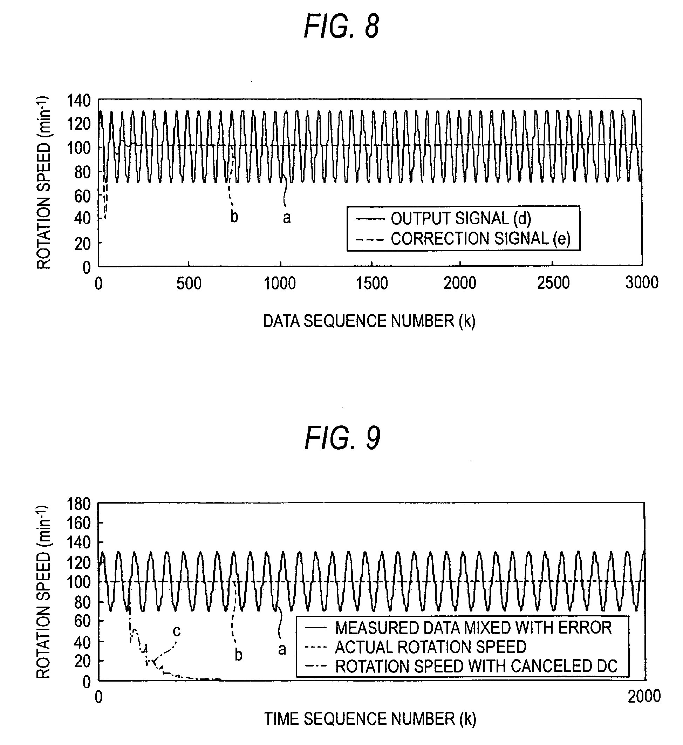

Fig. 8 shows an example of a simulation with regard to operation of restraining the variation based on whirling of the encoder by using the adaptive filter 28. Fig. 8 shows a case in which a rotation speed of a rotating member rotated at constant speed of 100 min$^{-1}$ is measured by an encoder of 60 pulses/one rotation. A bold line a indicates a result in which a detecting result of a rotation speed detecting sensor is subjected only to a moving average processing of tap number = 15 (only an averaging filter is provided) (in correspondence with the output signal d). In this case, by whirling of the encoder, a calculated value of the rotation speed is varied between about 70 through 130 min$^{-1}$. Further, an amount of whirling the encoder is set to be considerably larger than a value which is actually produced.

In contrast thereto, a broken line b shows a result of correcting data after moving average indicated by the bold line a by using the adaptive filter (in correspondence with the modified signal e). As is apparent from the broken line b, although the calculated value is varied immediately after starting the adaptive filter, the filter coefficient is adapted by itself after an elapse of a short period of time and a calculation result is converged into a constant value of substantially 100 min$^{-1}$. Therefrom, it is known that by using both of the average filter and the adaptive filter, even when the encoder having the pitch error and a large deviation between the rotational center and the geometrical center (whirled) is used, the rotation speed of the rotating member can accurately be calculated.

Further, in calculating two pieces of the lines a, b shown in Fig. 8, as the reference signal x, a sine wave constituting one period by 60 pulses is formed by itself while counting a pulse number in a speed calculating apparatus. Further, step parameters of the adaptive filter are set such that μ = 0.002, tap number N = 30.

(Second Embodiment)

Figs. 9 through 12 show a second embodiment of the invention. A characteristic of the case of the embodiment resides in that processings can be executed in a low cost calculating unit (CPU) in which a calculating speed is not particularly fast by considerably reducing a number of times of calculating processings necessary for a detecting signal of a rotation detecting sensor at each pulse of an encoder. For that purpose, in the case of the embodiment, a synchronizing type LMS algorism is used to be able to considerably reduce a calculation amount. However, when the synchronizing type LMS algorism is simply used, simultaneously with correcting (canceling) a rotation primary component constituting whirling of the encoder, also a DC level indicating a rotation speed constituting an object of detection is also corrected (canceled). Thereby, an inherent function of the rotation speed detecting apparatus is lost and therefore, a null point of the filter coefficient is monitored and null point correction is executed for preventing the DC level from being canceled. The characteristic of the embodiment conceived from such a view point will be explained as follows. Further, also in the example shown in Fig. 8, there is a case in which the DC level is deviated delicately although the deviated level is a level which is not problematic practically. Therefore, in order to carry out a control with a higher accuracy, also in this case, it is preferable to execute the null point correction.

Although all of the above-described respective equations (2) (3) (4) are simple equations utilized for making the adaptive filter proper in the above-described first embodiment, in the actual application, there is conceivable a case in which a calculation amount becomes problematic. For example, when the tap number of the adaptive filter is set as N = 60, a total of 241 times of operation of 60 times of multiplication in Equation (2), one time of subtraction in Equation (3), 180 times of 120 times of multiplication and 60 times of addition in Equation (4) need to be executed at each pulse of the encoder. Therefore, a calculation amount necessary for calculating a revolution speed of double rows of rolling members provided at a single piece of rolling bearing unit becomes 482 times/1 pulse. Although the calculation amount (number of times of operations) is not unable to be processed physically, it is necessary to use comparatively expensive CPU having a fast processing speed. For example, when rotation speeds of wheels for an automobile (4 pieces of wheels) are detected for controlling a vehicular running stabilizing apparatus of ABS, TCS, VSC or the like, it is necessary to use 4 pieces of expensive CPU (or, high speed CPU capable of executing four operations of 241 times $\times$ 2 $\times$ 4 = 1928 times) to cause to increase cost of the vehicular running stabilizing apparatus and therefore, the constitution is not preferable.

In view of such a situation, in the case of the embodiment, it is intended to enable to use low cost CPU by considerably reducing a calculation amount by using the synchronizing LMS algorism. However, when the adaptive filter is operated by the synchronizing type LMS algorism, the adaptive filter cancels not only a whirling component of the encoder but also a DC component indicating the rotation speed when constituted in this way. A phenomenon of canceling the DC component in this way is significant when the synchronizing LMS algorism is used. Hence, in the case of the embodiment, the DC level indicating the rotation speed is made to be able to be detected accurately by providing a function of nullifying the output value of the adaptive filter.

First, a principle of operating the synchronizing type LMS algorism will be explained. In the block diagram shown in Fig. 5, the reference signal x inputted to the adaptive filter 28 may be a signal represented by whirling or the like of the encoder and related with a rotation n degree (n is a positive integer) component of the encoder and therefore, the signal may be one impulse signal per one rotation of the encoder. Hence, assume a case in which the reference signal x is the one impulse signal, at the same time, the tap number N of the adaptive filter 28 is equal to a pulse number per one rotation of the encoder. In this case, the reference signal x used in calculation at an instance of a time sequence k is expressed by Equation (6) shown below.

$$[x(k), \; x(k-1), \; x(k-2), \; \ldots, \; x(k-j), \; \ldots, (k-N+1)] = [\overset{0}{0}, \; \overset{1}{0},$$
$$\overset{2}{0}, \; \ldots, \; \overset{j}{1}, \; \ldots, \; \overset{N-1}{0}] \; \ldots \; (6)$$

In Equation (6), a position j at which the reference signal x becomes the impulse of a value of 1 is shifted one by one to the right side in accordance with progress of the time sequence k and when the position j is shifted to "N-1"-th on the rightmost side, in a next time sequence, a new impulse value is expressed at 0-th on the leftmost side. That is, the reference signal x becomes a data sequence for only circulating the position of the impulse having the Value 1 from 0-th to (N-1)-th. When Equation (6) is applied to Equations (2) (4), Equations (7) (8) are provided as follows.

$$y(k) = \sum_{i=0}^{N-1} w_k(i) \cdot x(k-i) = w_k(j) \cdot x(k-j) = w_k(j) \; \ldots \; (7)$$

$$w_{k+1}(j) = w_k(j) + 2\mu \cdot e(k) \cdot x(k-j) = w_k(j) + 2\mu \cdot e(k) \; \ldots \; (8)$$

Whereas when the adaptive filter 28 is operated by the normal LMS algorism which is not a synchronizing type, as described above, it is necessary to repeatedly execute calculations shown in respective Equations (2) (3) (4), when the adaptive filter is operated by the synchronizing type LMS algorism, only calculations shown in Equations (7) (8) and Equation (3) may be executed. For example, in a case in which the tap number N of the adaptive filter 28 is set to 60, when the adaptive filter 28 is operated by the normal LMS algorism, a total of a number of times of operation for each pitch of the encoder becomes 214 times as described above. In contrast thereto, when the adaptive filter 28 is operated by the synchronizing type LMS algorism, the operation is executed only substituting data in Equation (7), and four operations of a total of 3 times of one time of subtraction in Equation (3), 2 times of 1 time of multiplication and 1 time of addition in Equation (8) may be executed for each pulse of the encoder. That is, by adopting the synchronizing type LMS algorism, in comparison with a case in which the synchronizing type LMS algorism is not adopted, a number of times of operation can be reduced by about 1/80.

However, when the synchronizing type LMS algorism is adopted for operating the adaptive filter 28, in order to prevent also the DC component constituting the signal expressing the rotation speed from being canceled, it is necessary to correct the null point of the adaptive filter 28. The null point correction will be explained as follows. Fig. 9 shows an example of an error in detecting a speed by whirling of an encoder as a specific example of a phenomenon needing the null point correction. A diagram shown in Fig. 9 shows a case in which similar to the case of Fig. 8, a rotation speed of a rotating member rotated at a constant speed of 100 min$^{-1}$ is measured by an encoder of 60 pulses/1 rotation. A bold line a shows a result of subjecting a detection result of the rotation speed detecting sensor to a moving average processing of tap number = 15 (providing only an averaging filter) (in correspondence with an output signal d of Fig.

10). In this case, by whirling the encoder, a calculated value of the rotation speed is varied between about 70 through 130 min-1. Further, an amount of whirling the encoder is set to be considerably larger than an actually produced value.

When measured date with regard to the rotation speed as shown by the bold line a in Fig. 9 is processed by using the adaptive filter 28 as shown by Fig. 5 to cancel the error based on whirling of the encoder, depending on a set value of the adaptive filter 28, there is a possibility of canceling a DC level (signal representing 100 min-1 indicated by a broken line b in Fig. 9 of the rotation speed) constituting an object of detection in addition to the error component based on the whirling. The phenomenon of canceling also the necessary DC level in this way is significant when the synchronizing type LMS algorism for operating the adaptive filter is adopted. A chain line c shown in Fig. 9 is a specific example thereof.

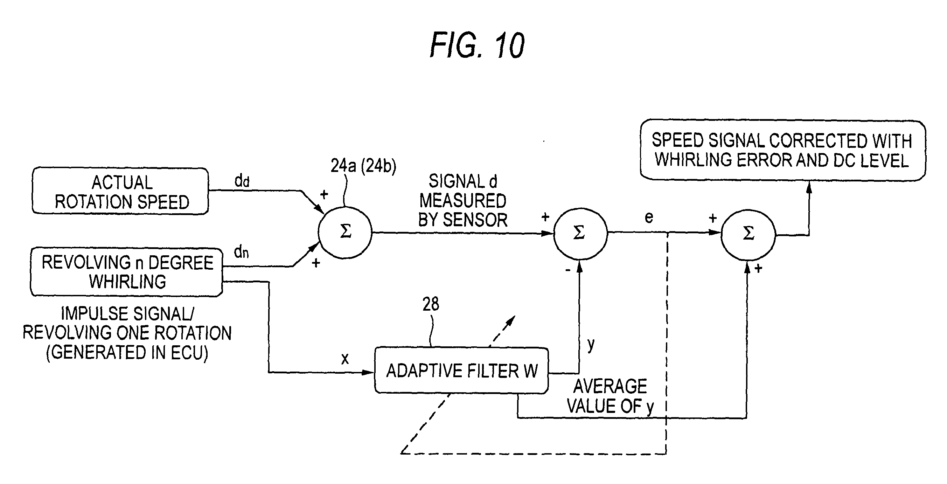

When the synchronizing type LMS algorism for operating the adaptive filter is adopted and a measure is not carried out particularly, as shown by the chain line c, not only the variation component based on whirling of the encoder but also the DC component indicating the rotation speed are canceled to nullify the output value. This is a phenomenon in which a filter coefficient W of the adaptive filter 28 carries away a DC level by the adaptive operation, as a result, the output signal y of the adaptive filter 28 carries away the DC level. In order to resolve the problem, in the case of the embodiment, as shown by Fig. 10, the DC level is calculated from an average value of the filter coefficient W and a DC signal constituted by multiplying the DC level by an impulse value of the reference signal x is calculated (when the impulse value is 1, the multiplication is not needed). Further, by adding the DC signal calculated as described above to a signal e in which the error is canceled by the adaptive filter 28, the DC level indicating the accurate rotation speed is provided.

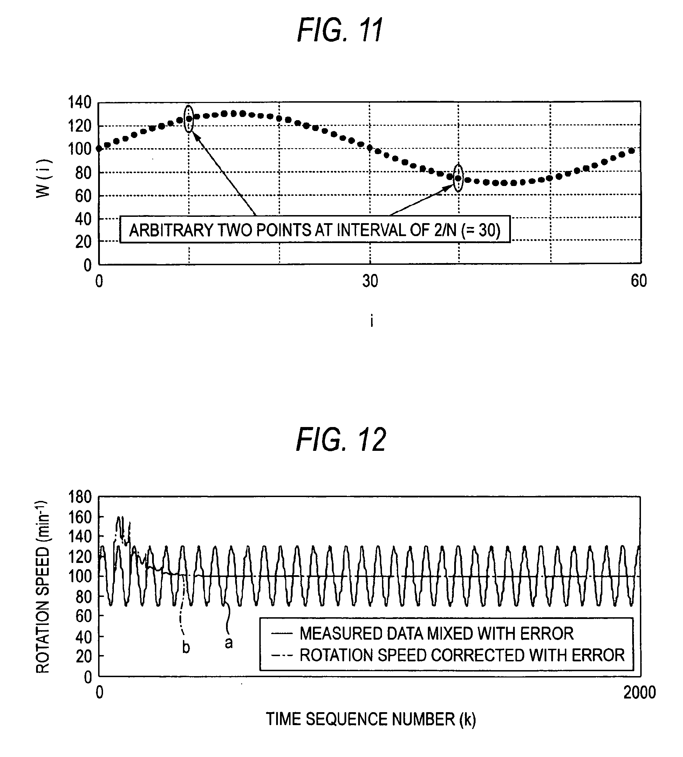

Next, an explanation will be given of a method of calculating the DC level from the average value of the filter coefficient W. A filter coefficient of the adaptive filter 28 is varied as shown by Fig. 11 when by operating the adaptive filter 28 by the synchronizing type LMS algorism, the error component included in the signal indicating the rotation speed provided from the output signal of the revolution speed detecting sensor 24a (24b) is canceled and the output value is nullified as shown by the chain line of Fig. 9. In the example shown in Fig. 9, the tap number N of the adaptive filter 28 is set to 60 and therefore, the filter coefficient W shown in Fig. 11 is constituted by 60 pieces of values. An average value of the filter coefficient W, that is, the DC level indicating the rotation speed to be calculated is calculated by totalizing all of 60 pieces of the values to be divided by 60. However, when such a calculation is executed, a number of times of operations is increased and low cost formation of CPU constituting the object of the embodiment cannot sufficiently be achieved.

Meanwhile, the object to be canceled as the error, that is, a waviness based on whirling the encoder is constituted by a rotation n degree component constituted mainly by a rotation primary component. Further, in the case of the embodiment, the tap number N of the adaptive filter is made to be equal to a number of pulses per one rotation of the encoder and therefore, the filter coefficient W becomes a periodic function having a period of L (= 60) . An average value of two arbitrary points set with an interval of N/2 (= 30) therebetween becomes equivalent to an average value of total points of N (= 60). Hence, when the average of the two points is calculated to constitute the DC level indicating the rotation speed, also the number of times of operations can considerably be reduced, which is advantageous in view of low cost formation of CPU. When a concern remains in reliability by the average of only the two points, other than the two points, two arbitrary points set with an interval of N/2 (= 30) therebetween are selected and an average value of a total of 4 points is calculated. Further, although not illustrated, even when the filter coefficient W is a periodic function of rotation n degree, the above-described average value can similar be calculated by pertinently increasing a number of points for calculating an average point and pertinently setting intervals thereof.

Fig. 12 shows an example of a simulation with regard to operation of restraining a variation based on whirling of an encoder by the structure of the embodiment. Fig. 12 shows a case in which a rotation speed of a rotating member rotated at a constant speed of 100 min-1 is measured by an encoder of 60 pulses/1 rotation. A bold line a is a result of subjecting a detection result of a rotation speed detecting sensor to a moving average processing of tap number = 15 (only an averaging filter is provided) (in correspondence with the output signal d). In this case, by whirling the encoder, a calculated value of the rotation speed is varied between about 70 through 130 min-1. A broken line b is a result of using the adaptive filter 28 operated by the synchronizing type LMS algorism shown in Fig. 10 and executing correction of the DC component by the filter coefficient W to thereby cancel the error component included in the signal expressing the rotation speed provided from the output signal of the revolution speed detecting sensor 24a (24b) . As is apparent from the broken line b, although data are varied immediately after starting the adaptive filter 28, the filter coefficient W is adapted by itself after elapse of a short period of time and a result of calculation is converged into a constant value of about 100 min-1.

(Third Embodiment)

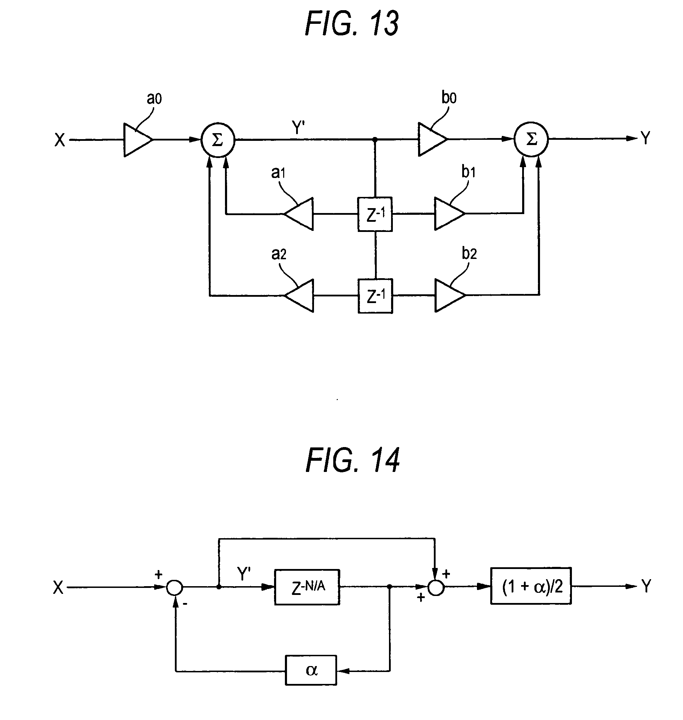

Fig. 13 shows a third embodiment of the invention. According to the embodiment, a low pass filter is used for restraining a variation based on whirling of an encoder referred to as an accumulated pitch error. That is, an error component of a rotation primary component is reduced by using a low pass filter set with a cut off frequency at a frequency lower than a frequency of a rotation primary component constituting a main component of the variation referred to as the accumulated pitch error. In this case, the low pass filter processes a signal calculated based on a detection signal of the rotation detecting sensor and expressing a rotation speed (the above-described signal shown in Fig. 7). Further, when the rotation speed of the encoder is changed, also a frequency of the rotation primary component is changed in proportion to the rotation speed. Therefore, in order to restrain the variation based on whirling the encoder by the low pass filter, the cut off frequency of the low pass filter needs to be changed in accordance with the rotation speed of the encoder.

For example, when a digital low pass filter is used, a sampling frequency of filter calculation is set not to a fixed frequency but to a sampling frequency in accordance with the rotation speed of the encoder. When the sampling frequency is set in this way, the cut off frequency can be changed in accordance with (in proportion to) the rotation speed of the encoder. Specifically, data for the filter calculation may be sampled at each time of outputting a pulse signal from a sensor opposed to the encoder. Fig. 13 is a flowchart (block diagram) expressing a diagram of constituting a low pass filter of IIR type by Z transformation as an example of a low pass filter of the frequency following type (degree number fixed type). Further, Equations (9) (10) shown below are calculating equations used for a processing at the low pass filter.

$$Y'(k) = a_0 \cdot X(k) + a_1 \cdot Y'(k-1) + a_2 \cdot Y'(k-2) \quad \ldots \quad (9)$$

$$Y(k) = b_0 \cdot Y'(k) + b_1 \cdot Y'(k-1) + b_2 \cdot Y'(k-2) \quad \ldots \quad (10)$$

In Fig. 13 and Equations (9) (10), notation X designates data inputted to the low pass filter, and is a signal calculated in correspondence with a pulse period or a pulse speed of the encoder and expressing the rotation speed. Further, notation Y designates an output of the low pass filter, notation Y' designates a signal processed in the low pass filter. Further, notation Y'(k-1) signifies Y' calculated by 1 piece past of current time (processing number k) and Y'(k-2) signifies Y' calculated by 2 pieces past of the current time (processing number k). Past Y'(k-1) and Y'(k-2) are stored in a memory or the like integrated to a processing circuit constituting the low pass filter. Although past Y' is not present in an initial state of calculation, the calculation may be started by substituting null therefor, or a pertinent value may be stored to the memory previously as an initial value. Further, coefficients $a_0$, $a_1$, $a_2$, bo, $b_1$, $b_2$ in Fig. 13 and two of Equations (9) (10) are constants for determining a cut off degree number of the low pass filter or a steepness degree of cut off and numerical values are substituted therefor to constitute a desired characteristic.

when the output signal of the sensor changed in accordance with rotation of the encoder is processed by a low pass filter functioning as in the flowchart shown in Fig. 13 by two of Equations (9) (10), a variation based on whirling the encoder, that is, an error component of a rotation primary component constituting the accumulated pitch error can be restrained. Further, the output signal of the sensor is processed by the low pass filter and therefore, other than the error component of the rotation primary component, also an error component having high frequency based on the above-described error of the magnetizing pitch can simultaneously be restrained. However, generally, when a signal is processed by using a low pass filter, a response delay is brought about. Therefore, the output signal of the sensor can be processed by the low pass filter as in the embodiment when the response delay is difficult to cause a problem. For example, as a case of conceiving a case in which a load is detected from the revolution speeds of the respective rolling members 9a, 9b and the rotation speed of the hub 2 in the rolling bearing unit for supporting the wheel as shown by Fig. 1 to which the embodiment is applicable, there are conceivable a case in which a slip force generated at a contact portion of a wheel and a road face in running an automobile is detected at a gradual curve, and a case of measuring a load applied to a rotational supporting portion of a machine tool, an industrial machine or the like. In such cases, even when more or less response delay is present in processing output signals of the revolution speed detecting sensors 24a, 24b and rotation speed detecting sensor 15a, a problem is difficult to be posed.

(Fourth Embodiment)

Fig. 14 shows a fourth embodiment of the invention. According to the embodiment, a notch filter is used for restraining a variation based on whirling of an encoder referred to as an accumulated pitch error. As described above, a response delay is generated when the above-described variation is restrained by the low pass filter and therefore, when a slip force produced at a contact portion between a wheel and a road face is detected in a state in which, for example, a lane is changed abruptly in running at high speed, a control for ensuring a running stability of a vehicle cannot sufficiently be carried out by using the low pass filter. Hence, in the case of the embodiment, the accumulated pitch error of the rotation primary component based on whirling of the encoder is restrained by the notch filter. Further, when a rotation speed of the encoder is changed, also a frequency of the rotation primary component is changed in proportion to the rotation speed and therefore, even when the notch filter is used, in order to restrain the variation based on whirling of the encoder, a cut off frequency of the notch filter needs to be changed in accordance with the rotation speed of the encoder.

Fig. 14 is a flowchart expressing a diagram of constituting a notch filter by Z transformation. Further, Equations (10) (11) shown below are calculating equations used in a processing by the notch filter.

$$Y'(k) = X(k) - \alpha \cdot Y'(k-N/A) \ \dots \ (11)$$

$$Y(k) = \{(1+\alpha)/2\} \cdot \{Y'(k) + Y'(k-N/A)\} \ \dots \ (12)$$

In Fig. 14 and Equations (11) (12), notation X designates data inputted to the notch filter and is a signal expressing a rotation speed calculated in correspondence with a pulse speed or a pulse speed of the encoder. Further, notation Y designates an output of the notch filter and notation Y' is a signal processed in the notch filter. Further, notation N designates a pulse number per one rotation (one revolution of a rolling member) of the encoder, notation A designates a constant specifying a notch frequency, notation $\alpha$ designates a constant for determining a steepness degree (influencing a converging performance), respectively.

Further, term Y' (k-N/A) signifies Y' calculated by N/A pieces past of current time (processing number k). In order to calculate Y' (k) at current time point in Equation (11), a value of Y' (k-N/A) multiplied by $\alpha$ is subtracted from the input X (k). Past Y' (k-N/A) is stored to a memory or the like integrated in a processing circuit constituting the notch filter. Although in an initial state of calculation, past Y' (k-N/A) is not present, the calculation may be started by substituting null therefor, or a pertinent value may be stored to the memory previously as an initial value.

The output Y of the notch filter is calculated by using newest Y' (k) and past Y' (k-N/A) as shown by Equation (12). In this case, by pertinently specifying the constant A specifying a notch frequency by combining with the pulse N per one rotation of the encoder, there is constituted a notch filter of a so-to-speak frequency following type (degree number fixed type) following a frequency changed by an increase or a reduction in the rotation speed. For example, when A = 2, there is constituted a notch filter for removing a rotation primary error component. Further, when the notation primary error component is restrained by the notch filter in this way, a response delay can more be reduced than in a case of using the low pass filter to be able to carry out a control for ensuring a running stability of the vehicle by detecting the slip force produced at the contact portion of the wheel and the road face in a state of abruptly changing a lane in running at high speed.

However, even in the case of the notch filter, although the response delay is smaller than that of the low pass filter, the response delay is invariably present and there is a possibility of posing a problem by the response delay. For example, a case of detecting a road face grip force at an instance of avoiding a hazard jumped out abruptly by fast steering. In order to be able to deal with even a case in which the response delay is hardly (not at all) permitted in this way, a method of correcting an error by using the adaptive filter is effective as in the first embodiment and the second embodiment. It is determined which filter is used in accordance with a case of requesting the fastest response. Also a structure of using both of a filter having a fast response and a filter having a slow response can be adopted depending on cases including the case of using both of the adaptive filter and the low pass filter as described above.

Although an explanation has been given of the invention in details and in reference to the particular embodiments, it is apparent for the skilled person that the invention can variously be changed or modified without deviating the sprit and the range of the invention.

The application is based on Japanese Patent Application (Japanese Patent Application No.2003-320058) filed on September 11, 2003, Japanese Patent Application (Japanese Patent Application No.2003-379536) filed on November 10, 2003, Japanese Patent Application (Japanese Patent Application No.2004-126311) filed on April.22, 2004, and the content is incorporated herein by the reference.

<Industrial Applicability>

The rotation speed detecting apparatus of the invention is not limited to the load measuring apparatus of the rolling bearing unit for measuring the load applied to the rolling bearing unit for supporting the wheel of the automobile as shown in the embodiments but can be utilized for detecting rotation speeds of rotating members of various rotating machine apparatus. In this case, a member for fixedly supporting the encoder is not limited to a member having a possibility of deviating a rotational center and a geometrical center as in a retainer but may be a rotating member in which the rotational center and the geometrical center are not deviated from each other as in a rotating shaft or the like. In this case, it is not necessary to particularly promote an accuracy of attaching an encoder to the rotating member to thereby reduce cost required in integration. Further, an encoder which can be used when the invention is embodied is not limited to a so-to-speak multipole magnet encoder in which S poles and N poles are alternately arranged in a rotational direction but includes encoders having various structures for providing information of rotation speeds such as a tone wheel, a gear, a slit disk and the like. Further, also a rotation detecting sensor is not limited to that of a magnetization detecting type but those of various structures of an optical type, an eddy current type and the like can be used.

**Claims**

1. A rotation speed detecting apparatus **characterized in** comprising:

   an encoder fixedly supported by a rotating member, rotated along with the rotating member and changing a characteristic thereof alternately in a circumferential direction;
   a rotation detecting sensor provided with a detecting portion thereof in a state of being opposed to a detected face of the encoder; and
   a calculating unit for calculating a rotation speed of the rotating member based on a detecting signal transmitted from the rotation detecting sensor and changed periodically;

   wherein the calculating unit includes a filter circuit for removing an influence of a variation of the detecting signal of the rotation detecting sensor constituting an error in calculating the rotation speed of the rotating member.

2. The rotation speed detecting apparatus according to Claim 1, wherein an error component in the detecting signal constituting an object to be removed as the influence of the variation by the filter circuit is constituted by a rotation primary component of the encoder.

3. The rotation speed detecting apparatus according to either of Claims 1 and 2, wherein the filter circuit is one or a plurality of kinds of digital filters or analog filters.

4. The rotation speed detecting apparatus according to any one of Claims 1 through 3, wherein the filter circuit is a low pass filter.

5. The rotation speed detecting apparatus according to any one of Claims 1 through 3, wherein the filter circuit is a notch filter.

6. The rotation speed detecting apparatus according to any one of Claims 1 through 5, wherein the filter circuit is a filter of a degree number fixed type for changing a cut off frequency in accordance with the rotation speed of the rotating member.

7. The rotation speed detecting apparatus according to Claim 1, wherein the filter is an adaptive filter.

8. The rotation speed detecting apparatus according to Claim 7, wherein a tap number of the adaptive filter is equal to a number of pulses per one rotation of the encoder.

9. The rotation speed detecting apparatus according to Claim 8, wherein the adaptive filter is operated by a synchronizing type LMS algorism.

10. The rotation speed detecting apparatus according to any one of Claims 7 through 9 wherein an average value of a filter coefficient of the adaptive filter is calculated and a DC level of the detecting signal of the rotation detecting sensor is corrected based on the average value.

11. The rotation speed detecting apparatus according to Claim 10, wherein the average value of the filter coefficient is an average value of the filter coefficients sampled at arbitrary two points present at equal intervals in a direction of rotating the encoder.

12. The rotation speed detecting apparatus according to Claim 10, wherein the average value of the filter coefficient is an average value of the filter coefficients at four points or more respectively constituting a plurality of combined data constituting a combination of pairs of the filter coefficients sampled at arbitrary two points present at equal intervals in the direction of rotating the encoder and.

13. The rotation speed detecting apparatus according to any one of Claims 7 through 12, wherein the adaptive filter removes an influence of the variation of the detecting signal of the rotation detecting sensor owing to an incoincidence between a rotational center and a geometrical center of the encoder.

14. The rotation speed detecting apparatus according to any one of Claims 7 through 13, wherein the adaptive filter is arranged in parallel with a main signal path for transmitting the detecting signal of the rotation detecting sensor and the influence of the variation of the detecting signal of the rotation detecting sensor is removed by subtracting an error component constituting an amount of the variation of the rotation detecting sensor calculated by the adaptive filter at a downstream portion of the main signal path.

15. The rotation speed detecting apparatus according to any one of Claims 7 through 14, wherein the adaptive filter is a digital filter or an analog filter operated by a steepest descent method.

16. The rotation speed detecting apparatus according to Claim 15, wherein the adaptive filter is a digital filter or an analog filter operated by an LMS algorism.

17. The rotation speed detecting apparatus according to any one of Claims 7, 8, 10, 11, 12, 13, 14, 15, 16, wherein a reference signal constituting an input of the adaptive filter is generated by the reference signal per se by a processing circuit of the detecting signal of the rotation detecting sensor opposed to the encoder, or a processing circuit for calculating the rotation speed of the rotating member based on the detecting signal.

18. The rotation speed detecting apparatus according to Claim 17, wherein the reference signal is constituted by any waveform of a sine wave, a triangular waveform, a sawtooth wave, a rectangular wave and a pulse wave constituting one period by one rotation of the encoder.

19. The rotation speed detecting apparatus according to any one of Claims 7 through 18, wherein with regard to the variation of the detecting signal of the rotation detecting sensor, a low pass filter is provided frontward or rearward from the adaptive filter for averaging a second variation based on a cause separate from a cause of the variation the influence of which is removed by the adaptive filter and having a period shorter than a period of the variation.

20. The rotation speed detecting apparatus according to any one of Claims 7 through 19, wherein the rotating member is a retainer provided between a pair of bearing rings constituting a rolling bearing unit and rotated in accordance with revolution of rolling members retained in a plurality of pockets.

21. The rotation speed detecting apparatus according to any one of Claims 7 through 20, wherein the detected face is one side face in an axial direction of the encoder.

22. A load measuring apparatus of a rolling bearing unit comprising:

> a stationary ring including two rows of stationary side tracks;
> a rotating ring arranged concentrically with the stationary ring and including two rows of rotating side tracks opposed to the two rows of the stationary side tracks;
> a plurality of rolling members rollably provided between the stationary side tracks and the rotating side tracks formed by respective two rows by respective pluralities of pieces thereof by directing directions of contact angles inverse to each other between the two rows;
> a pair of rotation speed detecting apparatus for detecting a rotation speed of a pair of retainers for retaining the two rows of the rolling members; and
> a calculating unit for calculating a load applied between the stationary ring and the rotating ring based on the rotation speed of the pair of retainers detected by the respective rotation speed detecting apparatus;

> wherein the respective rotation speed detecting apparatus are the rotation speed detecting apparatus according to Claim 20.

23. The load measuring apparatus of a rolling bearing unit according to Claim 22, wherein the rotating ring is a hub rotated along with a wheel in a state of being fixed to the wheel of an automobile.

# FIG. 1

# FIG. 2

FIG. 3

25

21a (21b)

9a (9b)

S

N

26a (26b)

24a (24b)

S

N

FIG. 4

9a

αa

8

8

9b

3

2

αb

PRELOAD (Fo)

PRELOAD (Fo)

αa

RADIAL
LOAD (Fr)

αb

9b

AXIAL LOAD (Fa)

9a

7

1

7

## FIG. 5

ACTUAL ROTATION SPEED

INFLUENCE BY WHIRLING

24a (24b)

$d_d$ +

$d_n$ +

Σ

SIGNAL d
MEASURED
BY SENSOR

+

Σ

e

CORRECTED SPEED SIGNAL

-

x

28

ADAPTIVE FILTER W

y

EP 1 672 372 A1

## FIG. 6

## FIG. 7

## FIG. 8

## FIG. 9

# FIG. 10

SPEED SIGNAL CORRECTED WITH WHIRLING ERROR AND DC LEVEL

ACTUAL ROTATION SPEED

REVOLVING n DEGREE WHIRLING

IMPULSE SIGNAL/ REVOLVING ONE ROTATION (GENERATED IN ECU)

SIGNAL d MEASURED BY SENSOR

ADAPTIVE FILTER W

AVERAGE VALUE OF y

## FIG. 11

ARBITRARY TWO POINTS AT INTERVAL OF 2/N (= 30)

## FIG. 12

— MEASURED DATA MIXED WITH ERROR
—·— ROTATION SPEED CORRECTED WITH ERROR

TIME SEQUENCE NUMBER (k)

## FIG. 13

## FIG. 14

# FIG. 15

# FIG. 16

## INTERNATIONAL SEARCH REPORT

| International application No. |
|---|
| PCT/JP2004/012700 |

### A. CLASSIFICATION OF SUBJECT MATTER
Int.Cl⁷ G01P3/481, G01D5/245

According to International Patent Classification (IPC) or to both national classification and IPC

### B. FIELDS SEARCHED

Minimum documentation searched (classification system followed by classification symbols)
Int.Cl⁷ G01P3/481, G01D5/245

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>A | JP 2-80964 A (Nippondenso Co., Ltd.),<br>22 March, 1990 (22.03.90),<br>Full text<br>(Family: none) | 1-6<br>7-23 |
| X<br>Y | JP 2000-206128 A (Toyota Motor Corp.),<br>28 July, 2000 (28.07.00),<br>Full text<br>(Family: none) | 1-21<br>22,23 |
| X<br>Y | JP 6-308139 A (Nippondenso Co., Ltd.),<br>04 November, 1994 (04.11.94),<br>Full text<br>& US 5541859 A & DE 4409846 A<br>& JP 6-270618 A | 1-21<br>22,23 |

☒ Further documents are listed in the continuation of Box C.    ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 06 December, 2004 (06.12.04) | 21 December, 2004 (21.12.04) |

| Name and mailing address of the ISA/<br>Japanese Patent Office | Authorized officer |
|---|---|
| Facsimile No. | Telephone No. |

Form PCT/ISA/210 (second sheet) (January 2004)

**EP 1 672 372 A1**

<table>
<tr><td colspan="2"><strong>INTERNATIONAL SEARCH REPORT</strong></td><td>International application No.<br>PCT/JP2004/012700</td></tr>
<tr><td colspan="3">C (Continuation). DOCUMENTS CONSIDERED TO BE RELEVANT</td></tr>
<tr><td>Category*</td><td>Citation of document, with indication, where appropriate, of the relevant passages</td><td>Relevant to claim No.</td></tr>
<tr><td>Y</td><td>JP 2001-21577 A (NSK Ltd.),<br>26 January, 2001 (26.01.01),<br>Full text<br>& US 2002/196989 A     & US 6471407 B</td><td>22,23</td></tr>
</table>

Form PCT/ISA/210 (continuation of second sheet) (January 2004)